(19) **Europäisches Patentamt / European Patent Office / Office européen des brevets**

(11) **EP 3 742 478 B1**

(12) **FASCICULE DE BREVET EUROPEEN**

(45) Date de publication et mention
de la délivrance du brevet:
**24.11.2021 Bulletin 2021/47**

(51) Int Cl.:
***H01L 21/60*** *(2006.01)*

(21) Numéro de dépôt: **20169487.4**

(22) Date de dépôt: **14.04.2020**

(54) **PROCÉDÉ D'AUTO-ASSEMBLAGE AVEC COLLAGE MOLÉCULAIRE HYBRIDE**

**SELBSTASSEMBLIERUNGSVERFAHREN MIT HYBRIDER MOLEKÜLVERBINDUNG**

**SELF-ASSEMBLY METHOD WITH HYBRID MOLECULAR BONDING**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **15.05.2019 FR 1905061**

(43) Date de publication de la demande:
**25.11.2020 Bulletin 2020/48**

(73) Titulaire: **Commissariat à l'Energie Atomique et
aux Energies
Alternatives
75015 Paris (FR)**

(72) Inventeurs:
• **JOUVE, Amandine
38054 GRENOBLE CEDEX 9 (FR)**
• **OLLIER, Emmanuel
38054 GRENOBLE CEDEX 9 (FR)**
• **ROLLAND, Emmanuel
38054 GRENOBLE CEDEX 9 (FR)**
• **SOUPREMANIEN, Ulrich
38054 GRENOBLE CEDEX 9 (FR)**

(74) Mandataire: **Cabinet Beaumont
4, Place Robert Schuman
B.P. 1529
38025 Grenoble Cedex 1 (FR)**

(56) Documents cités:
**FR-A1- 3 058 258    US-A1- 2018 130 765
US-B1- 9 773 741**

**Description**

Domaine technique

La présente description concerne de façon générale un procédé de collage moléculaire hybride de circuits électroniques et un circuit électronique permettant la mise en oeuvre d'un tel procédé.

Technique antérieure

Pour certaines applications, un circuit électronique ou plusieurs circuits électroniques, par exemple des circuits intégrés, sont fixés à un support par collage moléculaire. Le support correspond, par exemple, à un autre circuit intégré. Avant de fixer le circuit intégré au support, il est nécessaire de placer correctement le circuit intégré par rapport au support. Ceci peut être réalisé par un procédé d'auto-assemblage du circuit intégré sur le support.

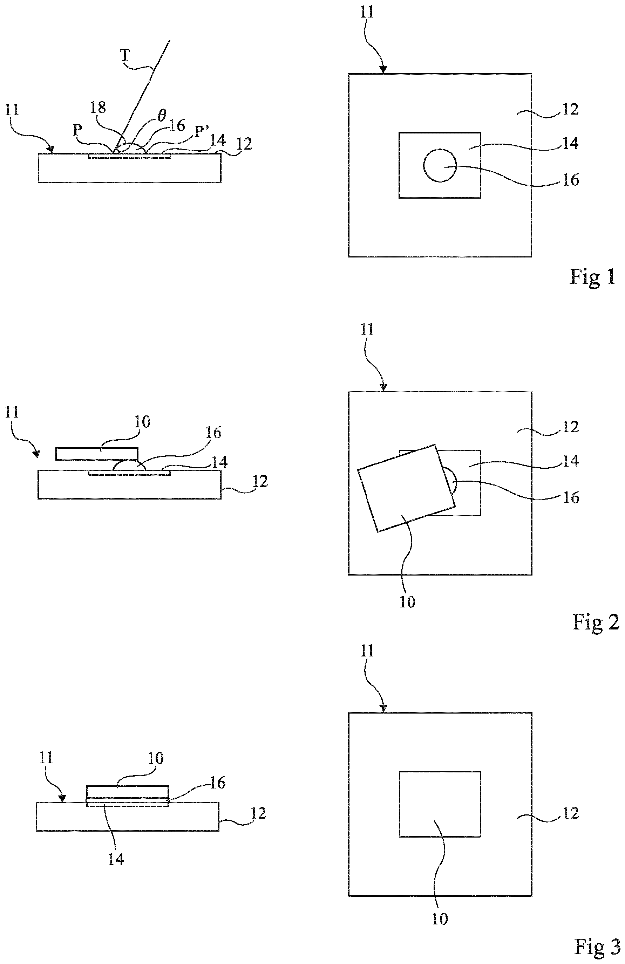

Les figures 1 à 3 représentent, en partie gauche, des vues en coupe et, en partie droite, des vues de dessus, partielles et schématiques, de structures obtenues à des étapes successives d'un exemple de procédé d'auto-assemblage d'un circuit électronique 10, par exemple un circuit intégré, sur un support 11.

Le support 11 présente en face supérieure une zone d'assemblage 14 à forte mouillabilité entourée par une zone périphérique 12 à faible mouillabilité. Le support 11 peut comprendre plusieurs zones d'assemblage 14. Une goutte 16 d'un liquide, par exemple de l'eau déminéralisée, est disposée sur la zone d'assemblage 14 (figure 1).

De façon générale, la mouillabilité d'un matériau peut être caractérisée par l'angle de contact $\theta$ d'une goutte de liquide sur le matériau. Plus l'angle de contact est faible, plus la mouillabilité du matériau est élevée. Dans le plan de coupe de la figure 1, l'interface 18 liquide/air de la goutte 16 est en contact avec la zone d'assemblage 14 aux points de contact P et P'. On appelle T la tangente à l'interface 18 au point de contact P (ou P'). L'angle de contact $\theta$ de la goutte 16 sur la zone d'assemblage 14 est l'angle entre la tangente T et la surface de la zone d'assemblage 14 qui est sensiblement horizontale. Lorsque la goutte 16 est au repos, l'angle $\theta$ mesuré est l'angle de contact statique.

Le circuit électronique 10 est alors approché de la zone d'assemblage 14 jusqu'à venir au contact de la goutte 16. Dans cette phase d'approche, le circuit électronique 10 peut être décalé et incliné par rapport à la zone d'assemblage 14 (figure 2).

Les forces exercées par la goutte 16 sur le circuit électronique 10 déplacent alors le circuit électronique 10 jusqu'à l'alignement souhaité par rapport à la zone d'assemblage 14 (figure 3) sans qu'aucune action extérieure ne soit nécessaire.

Le procédé de fixation du circuit électronique 10 au support 11, par exemple par collage moléculaire hybride, peut alors être mis en oeuvre. Le collage moléculaire hybride permet d'empiler des circuits électroniques les uns sur les autres avec une interconnexion électrique entre eux.

Pour que le procédé d'auto-assemblage se déroule convenablement, il est nécessaire que la goutte 16 reste confinée sur la zone d'assemblage 14 tout au long de l'alignement du circuit électronique 10 par rapport au support 11. Dans l'exemple de procédé d'auto-assemblage décrit précédemment, le confinement de la goutte 16 sur la zone d'assemblage 14 tout au long du procédé d'auto-assemblage est obtenu par la différence de mouillabilité entre la zone d'assemblage 14 et la zone périphérique 12. Plus la différence de mouillabilité est élevée, plus la goutte 16 tend à rester confinée sur la zone d'assemblage 14.

Par exemple, le document FR 3 058 258 A1 divulgue un procédé de collage hybride basé sur une telle étape d'auto-assemblage d'un circuit électronique sur un support. Afin d'améliorer le confinement de la goutte de liquide pour l'étape d'auto-assemblage, DI prévoit, dans une zone périphérique du circuit électronique, des deuxièmes plots en un matériau hydrophobe qui est différent du matériau des premiers plots du circuit électronique et qui forme une surface de confinement de la goutte.

Toutefois, avec les procédés connus, il peut être difficile d'obtenir une différence de mouillabilité importante entre la zone d'assemblage 14 et la zone périphérique 12. Il peut alors se produire des erreurs de placement de la goutte 16 sur le support 11 et la goutte 16 peut quitter la zone d'assemblage 14 au cours du procédé d'auto-assemblage.

Il existe donc un besoin d'améliorer le confinement de gouttes de liquide sur un support pour la mise en oeuvre d'un procédé d'auto-assemblage.

Il est, en outre, souhaitable que le procédé de fabrication des plots soit compatible avec les techniques classiques de fabrication de circuits électroniques.

Résumé de l'invention

Un objet d'un mode de réalisation est de pallier tout ou partie des inconvénients des supports connus comprenant des zones d'assemblage pour la mise en oeuvre d'un procédé d'auto-assemblage et des procédés connus de fabrication de tels supports.

Un autre objet d'un mode de réalisation est d'améliorer le confinement de gouttes de liquide sur des zones d'assemblage d'un support pour la mise en oeuvre d'un procédé d'auto-assemblage.

Un autre objet d'un mode de réalisation est d'augmenter la différence de mouillabilité entre chaque zone d'assemblage et la zone périphérique entourant la zone d'assemblage.

Un autre objet d'un mode de réalisation est que l'augmentation de la différence de mouillabilité entre chaque zone d'assemblage et la zone périphérique entourant la zone d'assemblage est obtenue sans ajouter de nouvelles étapes aux étapes connues d'un procédé de fabrication de circuits électroniques.

Un autre objet d'un mode de réalisation est que le procédé de fabrication des zones d'assemblage soit compatible avec les procédés classiques de fabrication de circuits électroniques.

Dans ce but, un mode de réalisation prévoit un premier circuit électronique tel que défini dans la revendication 1 et comprenant une première face plane, destinée à être fixée à un deuxième circuit électronique par un procédé d'auto-assemblage avec collage moléculaire hybride, des premiers plots conducteurs électriquement exposés sur la première face, le premier circuit électronique comprenant, en outre, une zone périphérique autour de la première face comprenant des deuxièmes plots exposés et en relief, chacun au moins en partie de même composition que les premiers plots.

Un mode de réalisation prévoit également un procédé de fabrication tel que défini dans la revendication 2 pour fabriquer un premier circuit électronique comprenant une première face plane, destinée à être fixée à un deuxième circuit électronique par un procédé d'auto-assemblage avec collage moléculaire hybride, et des premiers plots conducteurs électriquement exposés sur la première face, le procédé comprenant la formation d'une zone périphérique autour de la première face comprenant des deuxièmes plots exposés et en relief, chacun au moins en partie de même composition que les premiers plots.

Selon un mode de réalisation, le procédé comprend une étape de planarisation mécanochimique pour former une troisième face plane d'une couche isolante électriquement sur laquelle sont exposés les premiers plots et les deuxièmes plots et une étape de gravure de la couche isolante autour des deuxièmes plots pour délimiter la première face.

Selon un mode de réalisation, le procédé comprend une étape de recouvrement de la face d'assemblage d'une couche de résine, le dépôt d'une couche hydrophobe sur les deuxièmes plots et le retrait de la couche de résine.

Un mode de réalisation prévoit également un procédé d'auto-assemblage tel que défini dans la revendication 5 et comprenant le collage hybride de la première face plane d'un premier circuit électronique fabriqué comme cela est décrit précédemment à une deuxième face d'un deuxième circuit électronique, le deuxième circuit électronique comprenant des troisièmes plots conducteurs électriquement exposés sur la deuxième face, le procédé comprenant le dépôt d'une goutte d'un liquide sur la première face et la mise en contact de la deuxième face avec ladite goutte.

Selon un mode de réalisation, les troisièmes plots sont disposés de façon symétrique par rapport aux premiers plots.

Selon un mode de réalisation, les deuxièmes plots comprennent chacun un revêtement hydrophobe.

Selon un mode de réalisation, les deuxièmes plots sont disposés tout autour de la première face.

Selon un mode de réalisation, la zone périphérique comprend au moins une piste en relief entourant la première face, la piste étant au moins en partie de même composition que les premiers plots.

Selon un mode de réalisation, la zone périphérique comprend, autour de la première face, des barres en relief s'étendant de façon perpendiculaire aux bords de la première face, chaque barre étant au moins en partie de même composition que les premiers plots.

Selon l'invention, les sommets des deuxièmes plots sont en retrait par rapport à la première face.

Selon un mode de réalisation, le rapport entre l'aire des premiers plots, vue perpendiculairement à la première face, et l'aire de la première face est différent du rapport entre l'aire des deuxièmes plots, vue perpendiculairement à la zone périphérique, et l'aire de la zone périphérique.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, en partie droite, une vue en coupe et, en partie gauche, une vue de dessus, partielle et schématique, d'une structure obtenue à une étape d'un exemple de procédé d'auto-assemblage d'un circuit électronique sur un support ;

la figure 2 est une figure analogue à la figure 1 d'une structure obtenue à une étape ultérieure du procédé ;

la figure 3 est une figure analogue à la figure 1 d'une structure obtenue à une étape ultérieure du procédé ;

la figure 4 est une vue de dessus, partielle et schématique, d'un mode de réalisation d'un circuit électronique adapté à la réalisation d'un procédé d'auto-assemblage et de collage moléculaire ;

la figure 5 est une vue en coupe, partielle et schématique, du circuit électronique de la figure 4 ;

la figure 6 est une vue en coupe, partielle et schématique, d'une variante du circuit électronique de la figure 4 ;

la figure 7 est une vue de détail de la figure 5 représentant une goutte de liquide reposant sur le circuit électronique en dehors de la zone d'assemblage ;

la figure 8 est une vue de détail de dessus de la figure 5 ;

la figure 9 est une vue de détail de côté de la figure 5 ;

la figure 10 est une figure analogue à la figure 4 d'un autre mode de réalisation d'un circuit électronique adapté à la réalisation d'un procédé d'auto-assemblage et de collage moléculaire ;

la figure 11 est une figure analogue à la figure 4 d'un autre mode de réalisation d'un circuit électronique adapté à la réalisation d'un procédé d'auto-assemblage et de collage moléculaire ;

la figure 12 est une vue en coupe, partielle et schématique, de la structure obtenue à une étape d'un mode de réalisation d'un procédé de fabrication d'un dispositif électronique comprenant le circuit électronique représenté sur les figures 4 et 5 ;

la figure 13 illustre une autre étape du procédé ;

la figure 14 illustre une autre étape du procédé ;

la figure 15 illustre une autre étape du procédé ;

la figure 16 illustre une autre étape du procédé ;

la figure 17 illustre une autre étape du procédé ; et

la figure 18 illustre une autre étape du procédé.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un circuit électronique dans une position normale d'utilisation. Sauf précision contraire, les expressions "environ", "approximativement", "sensiblement", et "de l'ordre de" signifient à 10 % près, de préférence à 5 % près. Dans la suite de la description, le terme "conducteur" signifie conducteur électriquement et le terme "isolant" signifie isolant électriquement.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments. En outre, dans la suite de la description, on appelle "matériau à forte mouillabilité" par rapport à un liquide, par exemple de l'eau, un matériau pour lequel l'angle de contact statique d'une goutte du liquide sur le matériau est inférieur à 90° et "matériau à faible mouillabilité" par rapport à un liquide un matériau pour lequel l'angle de contact statique d'une goutte du liquide sur le matériau est supérieur à 90°. Dans le cas où le liquide est de l'eau, un matériau à forte mouillabilité est également appelé hydrophile et un matériau à faible mouillabilité est également appelé hydrophobe.

Le collage moléculaire hybride permet la fabrication d'un dispositif électronique comprenant un premier circuit électronique fixé à un deuxième circuit électronique avec une interconnexion électrique entre les premier et deuxième circuits électroniques, le premier circuit électronique correspondant par exemple à une puce de circuit intégré et le deuxième circuit électronique correspondant par exemple à un circuit interposeur. Un exemple de procédé de fabrication du dispositif électronique comprend la formation de première et deuxième plaques de circuits intégrés comprenant chacune une face d'assemblage correspondant à la face libre d'une couche isolante au niveau de laquelle affleurent des plots conducteurs. Au moins la deuxième plaque de circuits intégrés est alors découpée pour former des puces de circuits intégrés distinctes. L'une des puces est alors fixée à la première plaque par collage moléculaire hybride, mettant en contact les plots conducteurs et les couches isolantes de la face d'assemblage de la puce et de la première plaque. La première plaque peut ensuite être découpée pour séparer les dispositifs électroniques.

L'obtention d'un état de surface adapté à la réalisation d'un collage moléculaire implique généralement une étape de planarisation mécanochimique des plaques de circuits intégrés, également appelée CMP (sigle anglais pour Chemical-Mechanical Planarization), qui combine généralement gravure chimique et mécanique. Un tel procédé peut requérir que les différents matériaux présents en surface des plaquettes de circuits intégrés soient répartis de façon sensiblement homogène. C'est pourquoi il est généralement utilisé, pour chaque plaque, des plots conducteurs de mêmes dimensions, par exemple de forme carrée ou hexagonale, répartis de façon sensiblement homogène sur l'ensemble de la face sur laquelle est réalisée la CMP.

Selon l'invention, pour augmenter la différence de mouillabilités entre la zone d'assemblage et la zone périphérique entourant la zone d'assemblage du premier circuit électronique, après la réalisation de la CMP, la couche isolante située entre les plots conducteurs de la zone périphérique est partiellement gravée pour exposer partiellement les plots conducteurs de la zone périphérique. Les plots ainsi exposés forment des reliefs qui réduisent la mouillabilité de la zone périphérique et augmentent donc la différence de mouillabilités entre la zone d'assemblage et la zone périphérique si les dimensions et la répartition des plots respectent les critères décrits dans la suite de la description.

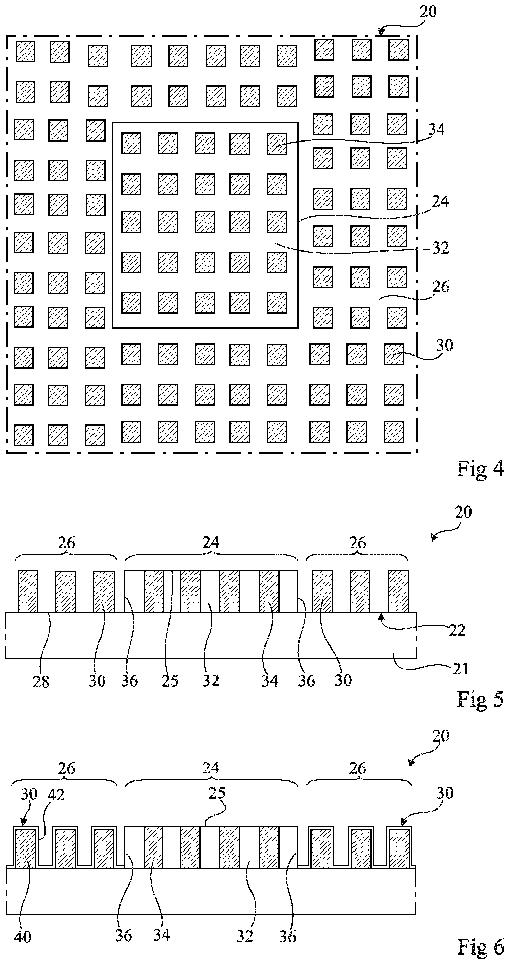

Les figures 4 et 5 sont respectivement une vue de dessus et une vue en coupe, partielles et schématiques, d'un mode de réalisation d'un premier circuit électronique 20, par exemple un circuit interposeur ou une puce de circuit intégré, sur lequel est destiné à être fixé au moins un deuxième circuit électronique, non représenté, par exemple une puce de circuit intégré, par un procédé d'auto-assemblage comprenant une étape de collage hybride. Le circuit électronique 20 est seulement représenté partiellement sur les figures.

Le circuit électronique 20 comprend un corps de circuit électronique 21 et une face 22 supérieure. La face supérieure 22 comporte une zone d'assemblage 24 entourée complètement par une zone périphérique 26. La face supérieure 22 peut comporter plus d'une zone d'assemblage 24, chaque zone d'assemblage étant entourée par une zone périphérique 26, lorsque plusieurs circuits électroniques sont fixés au circuit électronique 20.

Selon l'invention, la zone d'assemblage 24 comprend une face d'assemblage 25 sensiblement plane. Selon un mode de réalisation, la face d'assemblage 25 a, en vue de dessus, une forme symétrique de celle du circuit électronique auquel elle est destinée à être fixée.

La zone périphérique 26 comprend une surface de fond 28, de préférence sensiblement plane et en retrait par rapport à la face d'assemblage 25, depuis laquelle se projettent des plots conducteurs 30. La face d'assemblage 25 correspond à la face supérieure d'une couche isolante 32, des plots conducteurs 34 qui s'étendent dans la couche isolante 32, affleurant sur la face supérieure. La surface de fond 28 peut correspondre à la face supérieure de la couche isolante 32 dans la zone périphérique 26 ou correspondre à la face supérieure d'une autre couche isolante. La zone périphérique 26 peut elle-même être entourée par une zone, non représentée, ne participant pas au procédé d'auto-assemblage mais ayant de préférence sensiblement la même structure que la zone d'assemblage 24 pour permettre la mise en oeuvre d'une étape de CMP. Selon un mode de réalisation, la répartition des plots 30 et 34 est sensiblement uniforme sur l'ensemble du circuit électronique 20. A titre de variante, la répartition des plots 30 dans la zone périphérique 26 peut être différente de la répartition des plots 34 dans la zone d'assemblage 24. Selon un mode de réalisation, les plots 30 ont sensiblement les mêmes dimensions que les plots 34. Selon un autre mode de réalisation, au moins certains des plots 30, voire tous les plots 30, ont des dimensions différentes des plots 34.

Selon l'invention, les sommets des plots 30 peuvent être situés sensiblement dans le même plan que la face d'assemblage 25 ou en retrait de ce plan par rapport à la face d'assemblage 25. La distance entre la face d'assemblage 25 et la surface de fond 28 peut être comprise entre une centaine de nanomètres et quelques micromètres, typiquement entre 300 nm et 5 $\mu$m. La face d'assemblage 25 est reliée à la surface de fond 28 par des flancs 36 sensiblement perpendiculaires à la face d'assemblage 25. A titre de variante, les flancs 36 peuvent être inclinés par rapport à la face d'assemblage 25 d'un angle compris entre 10° et 90°, de préférence entre 45° et 90°. Les flancs 36 peuvent être inclinés de façon que la section droite des plots augmente en s'éloignant de la surface de fond 28. Ceci permet d'augmenter davantage la différence de mouillabilités entre la zone d'assemblage 24 et la zone périphérique 26.

Le corps 21 du circuit électronique 20 peut en outre comprendre un substrat, non représenté, dans lequel et sur lequel sont formés des composants électroniques, non représentés. Le substrat peut être recouvert d'un empilement, non représenté, de couches isolantes dans lequel sont formés des pistes métalliques de différents niveaux de métallisation et des vias conducteurs pour connecter les composants électroniques entre eux et les connecter à certains des plots 34. La couche isolante 32 est la couche isolante de l'empilement située au sommet de l'empilement de couches isolantes, à l'opposé du substrat.

Selon un mode de réalisation, la face d'assemblage 25 présente une mouillabilité élevée, l'angle de contact statique d'une goutte de liquide sur la face d'assemblage 25 étant inférieur ou égal à 15°, de préférence inférieur ou égal à 10°, plus préférentiellement inférieur ou égal à 5°. Comme cela sera décrit plus en détail par la suite, la présence des plots 30, et éventuellement leur préparation hydrophobe, confèrent une mouillabilité faible à la zone périphérique 26, l'angle de contact statique d'une goutte de liquide sur la zone périphérique 26 étant supérieur ou égal à 90°, de préférence supérieur ou égal à 110°. De ce fait, une goutte de liquide déposée sur la face d'assemblage 25, lors de la mise en oeuvre d'un procédé d'auto-assemblage, tend à ne pas quitter la face d'assemblage 25 pendant toute la durée du procédé d'auto-assemblage et une goutte de liquide, placée en partie sur la face d'assemblage 25 et en partie sur la zone périphérique 26, se déplace spontanément pour que toute la goutte d'eau se trouve sur la face d'assemblage 25.

La mesure de l'angle de mouillage peut être réalisée en utilisant l'appareil de mesure commercialisé par la société GBX sous l'appellation Digidrop - MCAT. La mesure comprend le dépôt d'une goutte du liquide utilisé lors du procédé d'auto-assemblage, par exemple d'eau déminéralisée, de 2 $\mu$l à 10 $\mu$l sur une surface du matériau à étudier, l'acquisition d'une image de la goutte par un dispositif d'acquisition d'images et la détermination de l'angle de contact par une analyse par ordinateur de l'image acquise.

La figure 6 est une figure analogue à la figure 5 d'une variante du circuit électronique 20 dans laquelle chaque plot 30 comprend un coeur 40 recouvert d'une couche 42 d'un matériau hydrophobe. La couche hydrophobe 42 peut également s'étendre sur la surface de fond 28 et éventuellement sur les flancs 36. Dans le mode de réalisation représenté en figure 5, les plots 30 ont la même composition que les plots 34. Dans la variante illustrée en figure 6, ce sont les coeurs 40 des plots 30 qui ont la même composition que les plots 34. Les plots 34 peuvent être composés d'un métal, ou d'un alliage métallique, notamment du cuivre (Cu), de l'aluminium (Al), du titane (Ti), ou du tungstène (W). Les plots 34 peuvent avoir une structure monocouche ou correspondre à un empilement d'au moins deux couches métalliques, par exemple un empilement Cu/Ti/TiN ou Cu/Ta/TaN. La couche isolante 32 peut être une monocouche, par exemple une couche d'oxyde de silicium ou de nitrure de silicium, ou avoir une structure multicouches comprenant un empilement de couches isolantes.

Selon un mode de réalisation, le matériau hydrophobe est un matériau fluoré, de préférence fluorocarboné. A titre d'exemple, la couche hydrophobe 42 est à base de composés fluorocarbonés de type $C_xF_y$, où x et y sont des nombres réels, x pouvant varier de 1 à 5 et y pouvant varier de 1 à 8. L'épaisseur de la couche hydrophobe 42 est, par exemple, comprise entre 1 nm et 300 nm.

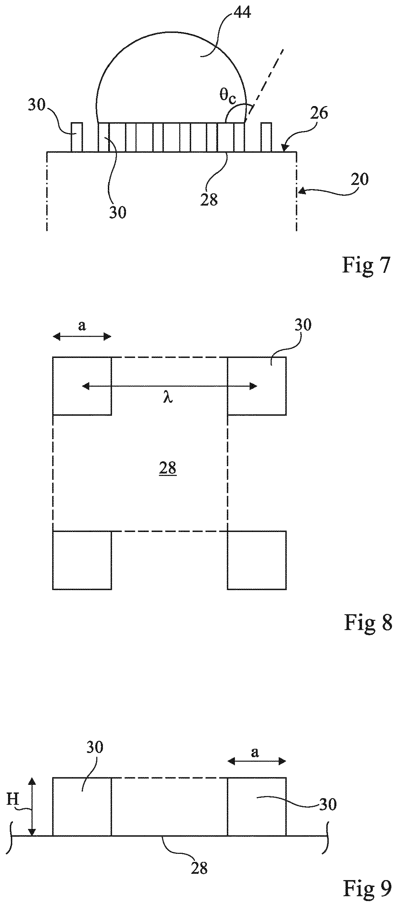

La figure 7 est une vue de détail de la figure 5, au niveau de la zone périphérique 26, représentant une goutte de liquide 44 reposant sur les plots 30 dans le cas où il n'y a pas de pénétration du liquide entre les plots 30 et les figures 8 et 9 illustrent des paramètres dimensionnels des plots 30. On va maintenant décrire trois paramètres dimensionnels d'un plot 30, sachant que ces paramètres peuvent être identiques ou différents d'un plot à l'autre.

On appelle hauteur "H" la hauteur du plot 30. De préférence, les plots 30 ont sensiblement la même hauteur "H". La section droite de chaque plot 30 dans un plan parallèle à la surface de fond 28 peut être sensiblement circulaire, ellipsoïdale ou polygonale, par exemple triangulaire, carrée ou rectangulaire. A titre de variante, la section droite de chaque plot 30 dans un plan parallèle à la surface de fond 28 peut avoir une forme quelconque. Dans la suite de la description, on appelle largeur "a" la plus petite dimension de la section droite du plot 30 dans un plan parallèle à la surface de fond 28. A titre d'exemple, lorsque le plot 30 a une section droite circulaire dans un plan parallèle à la surface de fond 28, la distance "a" peut correspondre au diamètre de la section droite et lorsque le plot 30 a une section droite carrée dans un plan parallèle à la surface de fond 28, la distance "a" peut correspondre au côté de la section droite. Le plot 30 peut avoir une forme généralement cylindrique, la section droite du plot 30 ne variant sensiblement pas en fonction de la distance à la surface de fond 28. A titre de variante, la section droite du plot 30 peut varier en fonction de la distance à la surface de fond 28. A titre d'exemple, le plot 30 peut avoir une forme générale conique ou tronconique.

On appelle pas "$\lambda$" la distance séparant les centres de deux plots 30 adjacents mesurée dans un plan parallèle à la surface de fond 28. Selon un mode de réalisation, les plots 30 sont de façon avantageuse répartis de façon sensiblement régulière dans la zone périphérique 26. Selon un mode de réalisation, le pas "$\lambda$" est sensiblement égal au double de la dimension "a" des plots 30.

Les dimensions des plots 30 sont choisies de façon que la goutte de liquide 44 repose sensiblement sur les sommets des plots 30 sans pénétrer entre les plots 30. En particulier, la hauteur "H" est suffisamment élevée et le pas "$\lambda$" est suffisamment faible pour que la goutte de liquide 44 déposée sur les plots 30 ne "s'empale" pas sur les plots 30 et ne vienne pas au contact de la surface de fond 28. Ceci est obtenu lorsque la hauteur "H" et le pas "$\lambda$" respectent la relation (1) suivante :

[Math 1]

$$H > \frac{\lambda |\tan(\theta_E)|}{\pi}$$

où $\theta_E$ est l'angle de mouillage de la goutte de liquide sur une surface plane du matériau présent en surface des plots 30.

Selon l'invention, un empalement partiel de la goutte de liquide 44 sur les plots 30 peut être autorisé.

Lorsque la goutte de liquide 44 repose sensiblement sur les sommets des plots 30, l'angle de contact statique "$\theta_C$" de la goutte de liquide 44 qui est mesuré est supérieur à l'angle de contact statique "$\theta_E$" que l'on obtient lorsque la goutte de liquide est disposée sur une surface plane composée du même matériau que le matériau en surface des plots 30.

Il existe plusieurs lois, appelées lois de Cassie ou lois de Cassie-Baxter, qui relient les angles de contact statiques "$\theta_C$" et "$\theta_E$" et qui dépendent notamment de la surface relative des plots 30. A titre d'exemple, pour des plots 30 ayant des sommets plats, les angles de contact statiques "$\theta_C$" et "$\theta_E$" sont reliés par la relation (2) suivante :

[Math 2]

$$\cos(\theta_C) = -1 + f\big(1 + \cos(\theta_E)\big)$$

où f est le rapport, en vue de dessus, entre la surface occupée par les plots 30 au contact de la goutte 44 et l'aire de la base de la goutte 44.

Dans le cas où les plots 30 sont cylindriques à base carrée, comme cela est représenté à titre d'exemple sur les figures 8 et 9, les angles de contact statiques "$\theta_C$" et "$\theta_E$" sont reliés par la relation (3) suivante :

[Math 3]

$$\cos(\theta_C) = -1 + \frac{a^2}{\lambda^2}\big(1 + \cos(\theta_E)\big)$$

Selon un mode de réalisation, le pas "À" est compris entre 300 nm et 20 $\mu$m. Selon un exemple, la hauteur "H" des plots 30 est supérieure à 430 nm pour une largeur de plots "a" de 500 nm, ce qui correspond à un pas "$\lambda$" de 1 $\mu$m. Selon un exemple, la hauteur "H" des plots 30 est supérieure à 4,3 $\mu$m pour une largeur de plots "a" de 5 $\mu$m, ce qui correspond à un pas "$\lambda$" de 10 $\mu$m. Ces dimensions sont compatibles avec les dimensions des plots formés de façon classique pour le collage moléculaire hybride de circuits électroniques.

Dans le mode de réalisation illustré sur les figures 4 et 5, les plots 30 sont répartis de façon sensiblement régulière dans la zone périphérique 26 et les plots 34 sont répartis de façon sensiblement régulière dans la zone d'assemblage 24. Dans le présent mode de réalisation, les plots 30 sont disposés dans la zone d'assemblage 26 en rangées et en colonnes. A titre de variante, les plots 30 peuvent être disposés en rangées, chaque rangée de plots étant décalée par rapport aux rangées adjacentes.

Pour que l'étape de CMP se déroule de façon convenable, selon un mode de réalisation, l'aire des surfaces métalliques exposées en vue de dessus sur la face supérieure du circuit électronique 20 obtenue après l'étape de CMP est inférieure à 50 %, de préférence comprise entre 15 % et 30 %, de l'aire de la face supérieure. Selon un mode de réalisation, sur la zone d'assemblage 24, l'aire exposée des plots 34 est inférieure à 50 %, de préférence comprise entre 15 % et 30 %, de l'aire de la zone d'assemblage 24. Selon un mode de réalisation, sur la zone périphérique 26, en vue de dessus, l'aire des plots 30 est inférieure à 50 %, de préférence comprise entre 15 % et 30 %, de l'aire de la zone périphérique 26. Selon un mode de réalisation, la zone périphérique 26 ne participant pas au collage, il y a moins de contraintes quant au rapport entre l'aire des plots exposés en vue de dessus et l'aire de la zone périphérique 26, qui, par exemple, peut être différent de celui de la zone d'assemblage 24, notamment être inférieur à 50 %.

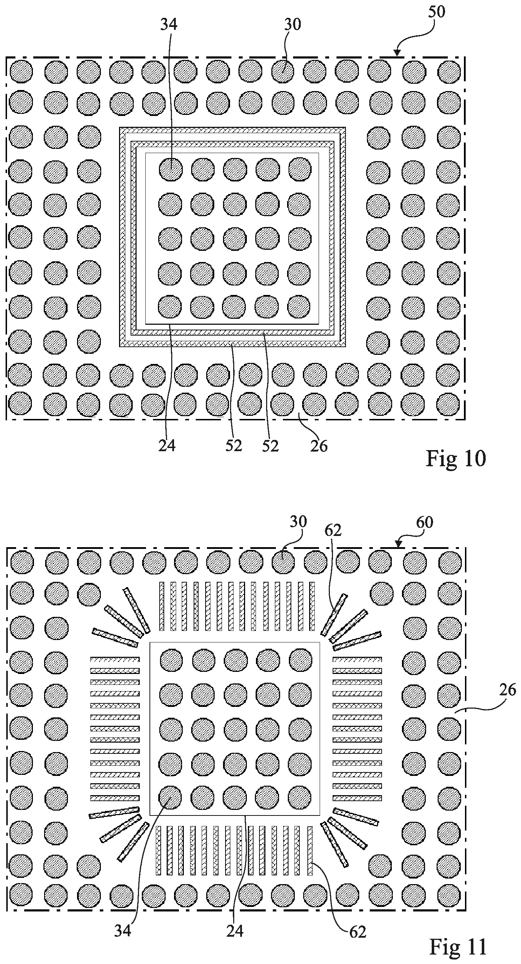

La figure 10 est une vue de dessus, partielle et schématique, d'un autre mode de réalisation d'un premier circuit électronique 50 sur lequel est destiné à être fixé au moins un deuxième circuit électronique, non représenté, par exemple une puce de circuit intégré, par un procédé d'auto-assemblage avec collage hybride. Le circuit électronique 50 comprend l'ensemble des éléments du circuit électronique 20 décrit précédemment en relation avec les figures 4 et 5 et comprend en outre, dans la zone périphérique 26, des pistes conductrices 52 entourant complètement la zone d'assemblage 24. A titre d'exemple, deux pistes 52 sont représentées en figure 10. Toutefois, une seule piste 52 entourant la zone d'assemblage 24 peut être présente ou plus de deux pistes 52 entourant la zone d'assemblage 24 peuvent être présentes. Les pistes 52 ont de préférence la même composition que les plots 30. Selon un mode de réalisation, la largeur des pistes 52 peut être inférieure ou supérieure à la dimension "a" décrite précédemment des plots 30. Les pistes 52 sont représentées continues en figure 10. A titre de variante, les pistes 52 peuvent présenter des interruptions.

Les pistes 52 jouent le rôle de barrage pour réduire les risques qu'une goutte de liquide présente sur la zone d'assemblage 24 ne quitte, en totalité ou en partie, la zone d'assemblage 24 pendant la mise en oeuvre du procédé d'auto-assemblage. En outre, les pistes 52 peuvent permettre de diminuer la mouillabilité de la zone périphérique 26 en présentant une surface développée plus importante que celle obtenue avec les plots 30.

La figure 11 est une vue de dessus, partielle et schématique, d'un autre mode de réalisation d'un premier circuit électronique 60 sur lequel est destiné à être fixé au moins un deuxième circuit électronique, non représenté, par exemple une puce de circuit intégré, par un procédé d'auto-assemblage avec collage hybride. Le circuit électronique 60 comprend l'ensemble des éléments du circuit électronique 20 décrit précédemment en relation avec les figures 4 et 5 et comprend en outre, dans la zone périphérique 26, des barres 62, disposées autour de la zone d'assemblage 24, s'étendant sensiblement de façon orthogonale par rapport aux bords de la zone d'assemblage 24, à l'exception des barres 62 situées au niveau des coins de la zone d'assemblage 24 qui peuvent s'étendre sensiblement radialement par rapport aux coins. Les barres 62 ont de préférence la même composition que les plots 30. Selon un mode de réalisation, la largeur des barres 62 peut être inférieure ou supérieure à la dimension "a" décrite précédemment des plots 30. Selon un mode de réalisation, la longueur de chaque barre 62 est supérieure ou égale à 10 fois la largeur de la barre 62.

Les barres 62 jouent le rôle de guides pour améliorer le déplacement d'une goutte de liquide vers la zone d'assemblage 24 lorsque la goutte de liquide est placée en partie sur la zone d'assemblage 24 et en partie sur la zone périphérique 26. En outre, les barres 62 peuvent permettre de diminuer la mouillabilité de la zone périphérique 26 en présentant une surface développée plus importante que celle obtenue avec les plots 30.

Dans les modes de réalisation illustrés sur les figures 10 et 11, il est prévu, dans la zone périphérique 26, des pistes conductrices 52 ou des barres 62 en plus des plots 30. De façon générale, il est prévu dans la zone périphérique 26 tout type de structures en relief, appelées de façon générique "plots", chacune de ces structures participant à l'augmentation de la différence de mouillabilités entre la zone périphérique 26 et la zone d'assemblage 24 associée et ayant au moins en partie la même composition que les plots 34.

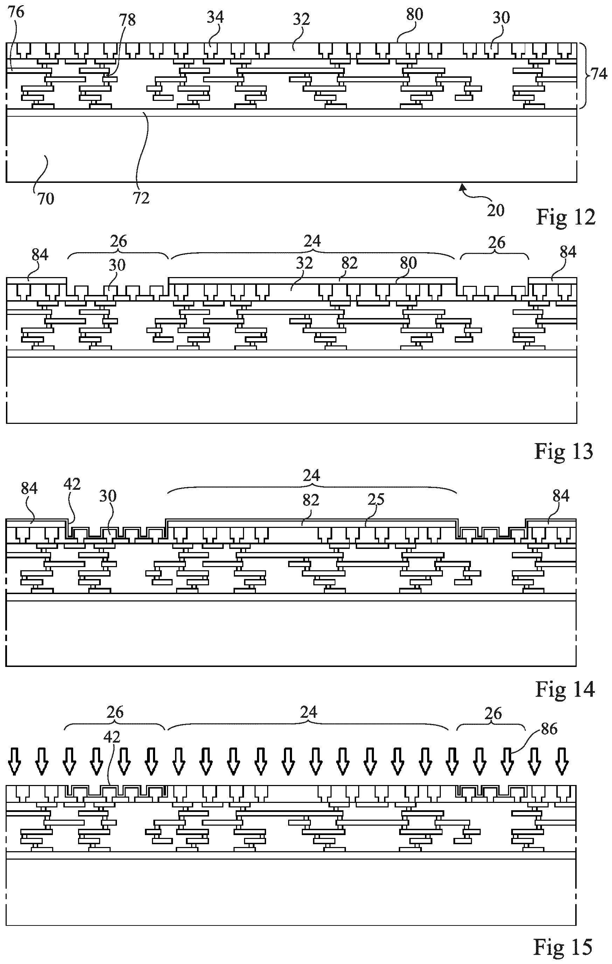

Les figures 12 à 18 sont des vues en coupe, partielles et schématiques, de structures obtenues à des étapes successives d'un mode de réalisation d'un procédé de fabrication d'un dispositif électronique comprenant un premier circuit électronique sur lequel est fixé un deuxième circuit électronique par un procédé d'auto-assemblage avec collage moléculaire hybride.

La figure 12 représente le premier circuit électronique 20. Sur les figures 12 à 18, on a représenté le premier circuit électronique 20 comprenant un substrat semiconducteur 70 dans et sur lequel sont réalisés des composants électroniques, ce qui est illustré de façon schématique par la région 72, le substrat 70 étant recouvert d'un empilement 74 de couches isolantes entre lesquelles sont formées des pistes conductrices 76 et au travers desquelles sont formés des vias conducteurs 78. La couche isolante 32 correspond à la dernière couche isolante de l'empilement 74, la plus éloignée du substrat 70. Le circuit électronique 20 comprend une face supérieure 80 qui correspond à la surface libre de la couche isolante 32. Les plots conducteurs 30 et 34 affleurent sur la face 80. Les plots conducteurs 30 et 34 correspondent donc à des pistes conductrices 76 du dernier niveau de métallisation. L'obtention de la face 80 est réalisée par une étape de CMP. A ce stade du procédé de fabrication, les plots 30 ont la même composition que les plots 34.

La figure 13 représente la structure obtenue après la formation sur la face 80, par des étapes de lithographie, d'une couche de résine 82 à l'emplacement souhaité de la zone d'assemblage 24 et d'une couche de résine 84 en dehors de l'emplacement souhaité de la zone périphérique 26 et après la gravure de la couche isolante 32 sur la totalité ou une partie de son épaisseur dans la zone périphérique 26 pour exposer une partie des plots 30 présents dans cette zone. Cette étape permet simultanément de délimiter la zone d'assemblage 24 et la zone périphérique 26. La gravure de la couche isolante 32 peut être une gravure mettant en oeuvre un plasma, notamment un plasma à base de tétrafluorure de carbone ($CF_4$) ou d'octofluorocyclobutane ($C_4F_8$), ou peut être une gravure humide, notamment à l'aide d'une solution d'acide fluorhydrique (HF) par exemple diluée à 0,25 %. La gravure est au moins partiellement sélective par rapport au matériau composant les plots 30. Toutefois, la gravure de la couche isolante 32 peut entraîner une légère gravure des plots 30. Le facteur de forme souhaité des plots 30, c'est-à-dire le rapport entre la largeur "a" et la hauteur "H" des plots 30, peut être commandé par la profondeur de la gravure.

La figure 14 représente la structure obtenue après la formation de la couche 42 du matériau hydrophobe. La couche 42 peut être déposée en mettant en oeuvre un plasma à base de $CF_4$ ou par un dépôt à la tournette dans le cas d'une couche hydrophobe liquide. Le procédé de dépôt de la couche hydrophobe 42 peut également entraîner le dépôt de cette couche sur les couches de résine 82, 84. Lorsque cette étape est présente, les plots 30 sont de préférence légèrement gravés lors de l'étape de gravure des plots 30 décrite précédemment de façon que la structure finale obtenue des plots 30 comprenant la couche hydrophobe 42 ne dépasse pas le plan contenant la face supérieure 25 de la zone d'assemblage 24.

La figure 15 représente la structure obtenue après le retrait des couches de résine 82, 84, par exemple par un procédé chimique liquide, et après la réalisation d'un traitement d'activation pour augmenter la mouillabilité de la zone d'assemblage 24. Le traitement peut comprendre un traitement par plasma (illustré par les flèches 86) ou un traitement chimique. La couche hydrophobe 42 est donc conservée sur les plots 30 de la zone périphérique 26. Le traitement d'activation peut ne pas être présent.

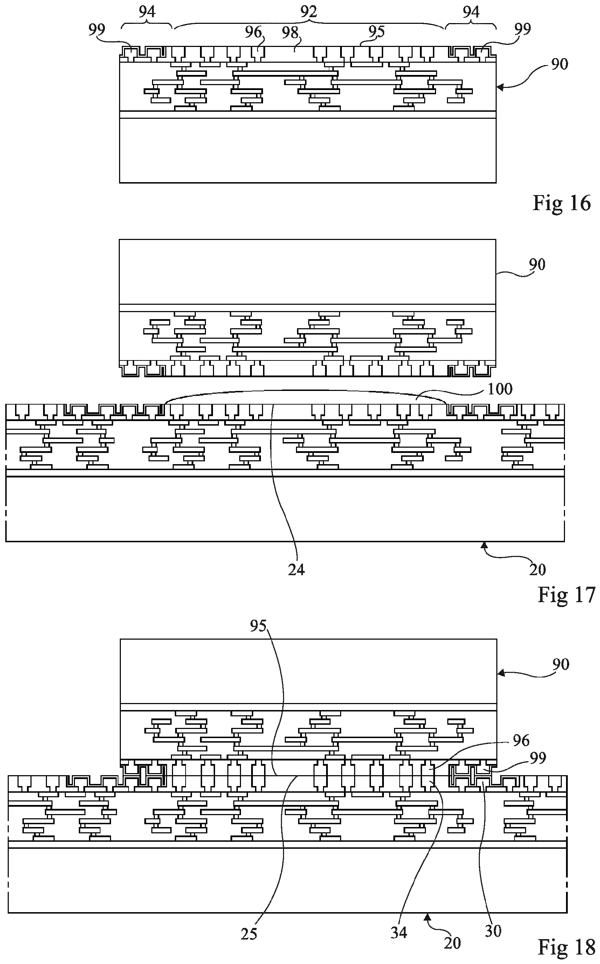

La figure 16 représente la structure obtenue après la formation d'un deuxième circuit électronique 90. Le deuxième circuit électronique 90 peut être formé par la mise en oeuvre des étapes décrites précédemment en relation avec les figures 12 à 15 et après une étape de découpe pour délimiter le deuxième circuit 90. En particulier, le circuit électronique 90 comprend une zone d'assemblage 92, de structure analogue à la zone d'assemblage 24 du premier circuit électronique 20, éventuellement entourée d'une zone périphérique 94, de structure analogue à la zone périphérique 26 du premier circuit électronique 20. La zone d'assemblage 92 comprend notamment une face d'assemblage 95 et des plots 96 séparés par une couche isolante 98 et la zone périphérique 94 comprend notamment des plots 99 en saillie. Si la technologie de découpe a une précision suffisante, le deuxième circuit électronique 90 peut ne comprendre que la zone d'assemblage 92.

La figure 17 représente la structure après le dépôt d'une goutte de liquide 100 sur la zone d'assemblage 24 du premier circuit électronique 20.

La figure 18 représente la structure après la mise en contact du deuxième circuit électronique 90 avec la goutte de liquide 92, ce qui entraîne un auto-assemblage du deuxième circuit électronique 92 sur le premier circuit électronique 20 avec, lors de l'évaporation de la goutte de liquide 92, un collage moléculaire du circuit électronique 90 au circuit électronique 20. De préférence, les plots 96 de la zone d'assemblage 92 du deuxième circuit électronique 90 sont agencés de façon symétrique par rapport aux plots 34 de la zone d'assemblage 24 du premier circuit électronique 20, de sorte que les plots 96 viennent au contact des plots 34 lors de l'étape de collage moléculaire.

Les plots 99 de la zone périphérique 94 du deuxième circuit électronique 90 sont de préférence agencés de façon symétrique par rapport aux plots 30 de la zone périphérique 26 du premier circuit électronique 20, de sorte que les plots 99 peuvent venir au contact des plots 30 lors de l'étape de collage moléculaire. Selon un autre mode de réalisation, les plots 99 de la zone périphérique 94 du deuxième circuit électronique 90 peuvent être agencés de façon non symétrique par rapport aux plots 30 de la zone périphérique 26 du premier circuit électronique 20, de sorte que les plots 99 ne viennent pas au contact des plots 30 lors de l'étape de collage moléculaire. Selon un autre mode de réalisation, les sommets des plots 99 de la zone périphérique 94 du deuxième circuit électronique 90 sont en retrait par rapport à la face d'assemblage 95 et/ou les sommets des plots 30 de la zone périphérique 26 du premier circuit électronique 20 sont en retrait par rapport à la face d'assemblage 25, de sorte que les plots 99 ne viennent pas au contact des plots 30 lors de l'étape de collage moléculaire.

Le procédé de CMP peut entraîner l'obtention d'une zone d'assemblage 24, 92, avant l'étape de collage, pour laquelle les plots 34, 96 sont légèrement en retrait par rapport à la surface plane exposée de la couche isolante 32, 98. Lors de la mise en contact du deuxième circuit électronique 90 et du premier circuit électronique 20, par exemple à température ambiante, le collage moléculaire a lieu dans un premier temps seulement entre la couche isolante 32 du premier circuit électronique 20 et la couche isolante 98 du deuxième circuit électronique 90. Une étape de recuit peut alors être réalisée, par exemple à environ 400°C. Cette étape entraîne la dilatation des plots 34 et 96 de sorte que les plots 96 viennent au contact des plots 34. On obtient alors un collage moléculaire entre les plots 96 et les plots 34.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, bien que dans les modes de réalisation décrits précédemment, les plots 30 de la zone périphérique 26 sont représentés disjoints, des plots 30 adjacents peuvent être reliés l'un à l'autre par une branche étroite du même matériau que les plots. En outre, bien que des modes de réalisation décrits précédemment concernent un dispositif électronique qui comprend l'empilement de deux circuits électroniques, il est clair que le dispositif électronique peut comprendre un empilement de plus de deux circuits électroniques, les modes de réalisation décrits précédemment pouvant s'appliquer à chaque interface entre deux circuits électroniques adjacents de l'empilement.

**Revendications**

1. Premier circuit électronique (20) comprenant une première face plane (25), destinée à être fixée à un deuxième circuit électronique (90) par un procédé d'auto-assemblage avec collage moléculaire hybride, et des premiers plots (34) conducteurs électriquement exposés sur la première face, le premier circuit électronique comprenant, en outre, une zone périphérique (26) autour de la première face comprenant des deuxièmes plots (30) exposés et en relief, ledit premier circuit électronique **caractérisé en ce que** chacun desdits deuxièmes plots est au moins en partie de même composition que les premiers plots, les dimensions des deuxièmes plots sont choisies de façon qu'une goutte (44) d'un liquide utilisé pour l'auto-assemblage repose sensiblement sur le sommet des deuxièmes plots ou ne s'empale que partiellement sur les deuxièmes plots, la zone périphérique (26) comprend une surface de fond (28) entre les deuxièmes plots (30) en retrait par rapport à la première face (25), les sommets des plots (30) sont situés sensiblement dans le plan contenant la première face (25) ou en retrait du plan contenant la première face (25).

2. Procédé de fabrication d'un premier circuit électronique (20) comprenant une première face plane (25), destinée à être fixée à un deuxième circuit électronique (90) par un procédé d'auto-assemblage avec collage moléculaire hybride, et des premiers plots (34) conducteurs électriquement exposés sur la première face, le procédé comprenant la formation d'une zone périphérique (26) autour de la première face comprenant des deuxièmes plots (30) exposés et en relief, ledit procédé **caractérisé en ce que** chacun desdits deuxièmes plots est au moins en partie de même composition que les premiers plots, les dimensions des deuxièmes plots sont choisies de façon qu'une goutte (44) d'un liquide utilisé pour l'auto-assemblage repose sensiblement sur le sommet des deuxièmes plots ou ne s'empale que partiellement sur les deuxièmes plots, la zone périphérique (26) comprend une surface de fond (28) entre les deuxièmes plots (30) en retrait par rapport à la première face (25), les sommets des deuxièmes plots (30) sont situés sensiblement dans le plan contenant la première face (25) ou en retrait du plan contenant la première face (25).

3. Procédé selon la revendication 2, comprenant une étape de planarisation mécanochimique pour former une troisième face (80) plane d'une couche isolante électriquement (32) sur laquelle sont exposés les premiers plots (34) et les deuxièmes plots (30) et une étape de gravure de la couche isolante autour des deuxièmes plots pour délimiter la première face (25).

4. Procédé selon la revendication 3, comprenant une étape de recouvrement de la première face (25) d'une couche de résine (82), le dépôt d'une couche hydrophobe (42) sur les deuxièmes plots (30) et le retrait de la couche de résine.

5. Procédé d'auto-assemblage avec collage hybride de la première face plane (25) d'un premier circuit électronique (20) fabriqué selon le procédé selon les revendications 2 à 4 à une deuxième face (95) d'un deuxième circuit électronique (90), le deuxième circuit électronique comprenant des troisièmes plots (96) conducteurs électriquement exposés sur la deuxième face, le procédé comprenant le dépôt de ladite goutte (100) du liquide sur la première face et la mise en contact de la deuxième face avec ladite goutte.

6. Procédé selon la revendication 5, dans lequel les troisièmes plots (96) sont disposés de façon symétrique par rapport aux premiers plots (34).

7. Circuit électronique selon la revendication 1 ou procédé selon la revendication 5 ou 6, dans lequel les deuxièmes plots (30) comprennent chacun un revêtement hydrophobe (42) .

8. Circuit électronique selon l'une quelconque des revendications 1 ou 7 ou procédé selon l'une quelconque des revendications 5 à 7, dans lequel les deuxièmes plots (30) sont disposés tout autour de la première face (25).

9. Circuit électronique selon l'une quelconque des revendications 1, 7 ou 8 ou procédé selon l'une quelconque des revendications 5 à 8, dans lequel la zone périphérique (26) comprend au moins une piste en relief (52) entourant la première face (25), la piste étant au moins en partie de même composition que les premiers plots (34).

10. Circuit électronique selon l'une quelconque des revendications 1, 7 à 9 ou procédé selon l'une quelconque des revendications 5 à 9, dans lequel la zone périphérique (26) comprend, autour de la première face (25), des barres en relief (62) s'étendant de façon perpendiculaire aux bords de la première face (25), chaque barre étant au moins en partie de même composition que les premiers plots (34) .

11. Circuit électronique selon l'une quelconque des revendications 1, 7 à 10 ou procédé selon l'une quelconque des revendications 5 à 10, dans lequel le rapport entre l'aire des premiers plots (34), vue perpendiculairement à la première face (25), et l'aire de la première face est différent du rapport entre l'aire des deuxièmes plots (30), vue perpendiculairement à la zone périphérique (26), et l'aire de la zone périphérique.

**Patentansprüche**

1. Eine erste elektronische Schaltung (20), die Folgendes aufweist

eine erste ebene Oberfläche (25), die an einer zweiten elektronischen Schaltung (90) mittels eines Selbst-Zusammenbau Verfahrens mit einem hybriden molekularen Bonding befestigt werden soll, und
erste elektrisch leitende Pads (34), die auf der ersten Oberfläche freigelegt sind, wobei die erste elektronische Schaltung ferner ein peripherer Bereich (26) um die erste Oberfläche herum aufweist mit zweiten freigelegten und erhöhten Pads (30), wobei die erste elektronische Schaltung ferner **dadurch gekennzeichnet ist, dass**

jedes der zweiten Pads wenigstens teilweise die gleiche Zusammensetzung hat wie die ersten Pads,
die Abmessungen der zweiten Pads so gewählt sind, dass ein Tropfen (44) einer Flüssigkeit, die für den Selbst-Zusammenbau verwendet wird, sich im Wesentlichen auf der Oberseite der zweiten Pads befindet oder nur teilweise von den zweiten Pads aufgespießt bzw. aufgeständert wird,
der periphere Bereich (26) eine Unterseite (28) zwischen den zweiten Pads (30) aufweist, die bezüglich der ersten Oberfläche (25) zurückgesetzt ist,
die oberen Enden der zweiten Pads (30) sich im Wesentlichen in der Ebene befinden, die die erste Oberfläche (25) enthält, oder von der Ebene, die die erste Oberfläche (25) enthält, zurückgesetzt sind.

2. Ein Verfahren zum Herstellen einer ersten elektronischen Schaltung (20), das Folgendes aufweist

eine erste ebene Oberfläche (25), die an einer zweiten elektronischen Schaltung (90) mittels eines Selbst-Zusammenbau Verfahrens mit einem hybriden molekularen Bonding befestigt werden soll, und
erste elektrisch leitende Pads (34), die auf der ersten Oberfläche freigelegt sind, wobei das Verfahren das Bilden eines peripheren Bereichs (26) um die erste Oberfläche herum aufweist mit zweiten freigelegten und erhöhten Pads (30), wobei das Verfahren ferner **dadurch gekennzeichnet ist, dass**

jedes der zweiten Pads wenigstens teilweise die gleiche Zusammensetzung hat wie die ersten Pads,
die Abmessungen der zweiten Pads so gewählt sind, dass ein Tropfen (44) einer Flüssigkeit, die für den Selbst-Zusammenbau verwendet wird, sich im Wesentlichen auf der Oberseite der zweiten Pads befindet oder nur teilweise von den zweiten Pads aufgespießt bzw. aufgeständert wird,
der periphere Bereich (26) eine Unterseite (28) zwischen den zweiten Pads (30) aufweist, die bezüglich der ersten Oberfläche (25) zurückgesetzt ist,
die oberen Enden der zweiten Pads (30) sich im Wesentlichen in der Ebene befinden, die die erste Oberfläche (25) enthält, oder von der Ebene, die die erste Oberfläche (25) enthält, zurückgesetzt sind.

3. Das Verfahren gemäß Anspruch 2, das einen Schritt aufweist zur chemisch mechanischen Planarisierung um eine dritte ebene Oberfläche (80) aus einer elektrisch isolierenden Schicht (32) zu bilden, bei der die ersten Pads (34) und die zweiten Pads (30) darauf freigelegt sind und einen Schritt zum Ätzen der isolierenden Schicht um die zweiten Pads herum um die erste Oberfläche (25) abzugrenzen.

4. Das Verfahren gemäß Anspruch 3, das einen Schritt aufweist zum Abdecken der ersten Oberfläche (25) mit einer Resin-Schicht (82), der Ablagerung einer hydrophoben Schicht (42) auf den zweiten Pads (30) und der Entfernung der Resin-Schicht.

5. Ein Verfahren zum Selbst-Zusammenbau mit einem hybriden Bonding der ersten ebenen Oberfläche (25) einer ersten elektronischen Schaltung (20), die gemäß dem Verfahren gemäß der Ansprüche 2 bis 4 hergestellt wird, mit einer zweiten Ebene (95) einer zweiten elektronischen Schaltung (90), wobei die zweite elektronische Schaltung dritte elektrisch leitende Pads (96) aufweist, die auf der zweiten Oberfläche freigelegt sind, wobei das Verfahren die Ablagerung des Tropfens (100) der Flüssigkeit auf der ersten Oberfläche aufweist und das in Kontakt bringen der zweiten Oberfläche mit dem Tropfen.

6. Das Verfahren gemäß Anspruch 5, wobei die dritten Pads (96) symmetrisch in Bezug auf die ersten Pads (34) angeordnet sind.

7. Die elektronische Schaltung gemäß Anspruch 1 oder das Verfahren nach Anspruch 5 oder 6, wobei die zweiten Pads (30) jeweils eine hydrophobe Beschichtung (42) aufweisen.

8. Die elektronische Schaltung gemäß Anspruch 1 oder 7 oder das Verfahren nach einem der Ansprüche 5 bis 7, wobei die zweiten Pads (30) überall um die erste Oberfläche (25) herum angeordnet sind.

9. Die elektronische Schaltung gemäß einem der Ansprüche 1, 7 oder 8, oder das Verfahren nach einem der Ansprüche 5 bis 8, wobei der periphere Bereich (26) wenigstens eine erhöhte Spur (52) aufweist, die die erste Oberfläche (25) umrundet, wobei die Spur wenigstens teilweise die gleiche Zusammensetzung hat wie die ersten Pads (34).

10. Die elektronische Schaltung gemäß einem der Ansprüche 1, 7 bis 9, oder das Verfahren nach einem der Ansprüche 5 bis 9, wobei der periphere Bereich (26), um die erste Oberfläche (25) herum, erhöhte Leisten (62) aufweist, die sich rechtwinklig zu den Kanten der ersten Oberfläche (25) erstrecken, wobei jede Leiste wenigstens teilweise die gleiche Zusammensetzung hat wie die ersten Pads (34).

11. Die elektronische Schaltung gemäß einem der Ansprüche 1, 7 bis 10, oder das Verfahren nach einem der Ansprüche 5 bis 10, wobei das Verhältnis des Oberflächenbereichs der ersten Pads (34), rechtwinklig zur ersten Oberfläche (25) betrachtet, zu dem Oberflächenbereich der ersten Oberfläche verschieden ist von dem Verhältnis des Oberflächenbereichs der zweiten Pads (30), rechtwinklig zu dem peripheren Bereich (26) betrachtet, zu dem Oberflächenbereich des peripheren Bereichs.

## Claims

1. A first electronic circuit (20) comprising a first planar surface (25), intended to be affixed to a second electronic circuit (90) by a self-assembly method with a hybrid molecular bonding, and first electrically-conductive pads (34) exposed on the first surface, the first electronic circuit further comprising a peripheral area (26) around the first surface comprising second exposed and raised pads (30), said first electronic circuit being **characterized in that** each of said second pads at least partly has the same composition as the first pads, the dimensions of the second pads are selected so that a drop (44) of a liquid used for the self-assembly rests substantially on the top of the second pads or impales only partially on the second pads, the peripheral area (26) comprises a bottom surface (28) between the second pads (30) recessed with respect to the first surface (25), the tops of the second pads (30) are located substantially in the plane containing the first surface (25) or recessed from the plane containing the first surface (25).

2. A method of manufacturing a first electronic circuit (20) comprising a first planar surface (25), intended to be affixed to a second electronic circuit (90) by a self-assembly method with a hybrid molecular bonding, and first electrically-conductive pads (34) exposed on the first surface, the method comprising the forming of a peripheral area (26) around the first surface comprising second exposed and raised pads (30), said method being **characterized in that** each of said second pads at least partly has the same composition as the first pads, the dimensions of the second pads are selected so that a drop (44) of a liquid used for the self-assembly rests substantially on the top of the second pads or impales only partially on the second pads, the peripheral area (26) comprises a bottom surface (28) between the second pads (30) recessed with respect to the first surface (25), the tops of the second pads (30) are located substantially in the plane containing the first surface (25) or recessed from the plane containing the first surface (25).

3. The method according to claim 2, comprising a step of chemical mechanical planarization to form a third planar surface (80) of an electrically-insulating layer (32) having the first pads (34) and the second pads (30) exposed thereon and a step of etching the insulating layer around the second pads to delimit the first surface (25).

4. The method according to claim 3, comprising a step of covering the first surface (25) with a resin layer (82), the deposition of a hydrophobic layer (42) on the second pads (30), and the removal of the resin layer.

5. A method of self-assembly with a hybrid bonding of the first planar surface (25) of a first electronic circuit (20) manufactured according to the method according to claims 2 to 4 to a second surface (95) of a second electronic circuit (90), the second electronic circuit comprising third electrically-conductive pads (96) exposed on the second surface, the method comprising the deposition of said drop (100) of the liquid on the first surface and the placing into contact of the second surface with said drop.

6. The method according to claim 5, wherein the third pads (96) are arranged symmetrically with respect to the first pads (34).

7. The electronic circuit according to claim 1 or the method according to claim 5 or 6, wherein the second pads (30) each comprise a hydrophobic coating (42).

8. The electronic circuit according to claim 1 or 7 or the method according to any of claims 5 to 7, wherein the second pads (30) are arranged all around the first surface (25).

9. The electronic circuit according to any of claims 1, 7 or 8 or the method according to any of claims 5 to 8, wherein the peripheral area (26) comprises at least one raised track (52) surrounding the first surface (25), the track at least partly having the same composition as the first pads (34).

**10.** The electronic circuit according to any of claims 1, 7 to 9 or the method according to any of claims 5 to 9, wherein the peripheral area (26) comprises, around the first surface (25), raised bars (62) extending perpendicularly to the edges of the first surface (25), each bar at least partly having the same composition as the first pads (34).

**11.** The electronic circuit according to any of claims 1, 7 to 10 or the method according to any of claims 5 to 10, wherein the ratio of the surface area of the first pads (34), seen perpendicularly to the first surface (25), to the surface area of the first surface is different from the ratio of the surface area of the second pads (30), seen perpendicularly to the peripheral area (26), to the surface area of the peripheral area.

Fig 1

Fig 2

Fig 3

Fig 4

Fig 5

Fig 6

Fig 7

Fig 8

Fig 9

Fig 10

Fig 11

Fig 12

Fig 13

Fig 14

Fig 15

Fig 16

Fig 17

Fig 18

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3058258 A1